# EUROPÄISCHE PATENTSCHRIFT

(11) **EP 3 514 837 B1**
(45) Veröffentlichungstag und Bekanntmachung des Hinweises auf die Patenterteilung: **03.06.2020**
(21) Anmeldenummer: 19000090.1
(22) Anmeldetag: 10.11.2017
(51) Int. Cl.: H01L 29/861, H01L 21/329, H01L 29/36, H01L 29/207, H01L 29/06

(54) **III-V-HALBLEITERDIODE**
III-V SEMICONDUCTOR DIODE
DIODE SEMI-CONDUCTRICE III-V

(30) Priorität: 14.11.2016 DE 102016013540
(43) Veröffentlichungstag der Anmeldung: 24.07.2019
(62) Teilanmeldung aus: 17001844.4
(73) Patentinhaber: 3-5 Power Electronics GmbH, 01217 Dresden (DE)
(72) Erfinder: Dudek, Volker, 76275 Ettlingen (DE)
(74) Vertreter: Koch Müller Patentanwaltsgesellschaft mbH

(56) Entgegenhaltungen:
- CN-U- 203 118 957
- DE-A1-102015 208 097
- US-A- 5 733 815
- A. KOEL: "Characterization of the temperature dependent behavior of snappy phenomenon by the switching-off of GaAs power diode structures", ADVANCES IN FLUID MECHANICS XI, Bd. 1, 1. Juli 2014 (2014-07-01), Seiten 439-449, XP055545469, Southampton UK ISSN: 1746-4471, DOI: 10.2495/HT140381 ISBN: 978-1-78466-105-2
- BHOJANI RITESHKUMAR ET AL: "Gallium arsenide semiconductor parameters extracted from pin diode measurements and simulations", IET POWER ELECTRO, IET, UK, Bd. 9, Nr. 4, 30. März 2016 (2016-03-30), Seiten 689-697, XP006055844, ISSN: 1755-4535, DOI: 10.1049/IET-PEL.2015.0019

## Beschreibung

Die Erfindung betrifft eine III-V-Halbleiterdiode.

Aus "GaAs Power Devices" von German Ashkinazi, ISBN 965-7094-19-4, Seite 8 und 9 ist eine hochspannungsfeste Halbleiterdiode p⁺ - n - n⁺ bekannt. Aus der US 5,733,815 A sowie B. Riteshukumar et al.: "Gallium arsenide semiconductor parameters extracted from pin diode measurements and simulations", IET Power Electronics, IET, UK, Bd. 9, Nr. 4, 30.03.2016, Seiten 689-697, XP006055844, ISSN: 1755-4535, SOI: 10.1049/iet-pel.2015.0019 sind pin-Dioden auf GaAs-Basis bekannt.

Aus DE 10 2015 208 097 ist ein Verfahren zur Einstellung der Dotierstoffkonzentration einer Driftschicht einer Halbleiterschichtfolge eines Halbleiterbauelements bekannt.

Aus A.Koel, "Characterization of the temperature dependent behavior of snappy phenomenon by the switching-off of GaAs power diode structures", Adavances in fluid mechanics XI, Bd. 1, July 2014, Seiten 439 -449, ISSN: 1746 - 4471, ISBN: 978-1-78466-105-2 ist eine GaAs Leistungsdiode bekannt, welche auf einem p⁺-Substrat, eine p-Schicht, eine sehr niedrig dotierte n-Schicht, eine niedrig dotierte n-Schicht und eine n⁺-Schicht umfasst, die mittels LPE (Liquid Phase Epitaxy) aufeinander abgeschieden werden.

Vor diesem Hintergrund besteht die Aufgabe der Erfindung darin, eine Vorrichtung anzugeben, die den Stand der Technik weiterbildet.

Die Aufgabe wird durch eine III-V-Halbleiterdiode mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine III-V-Halbleiterdiode bereitgestellt, aufweisend ein n⁺-Substrat mit einer Dotierstoffkonzentration mindestens 10¹⁹cm⁻³ und einer Schichtdicke von 50-400 µm, wobei das n⁺-Substrat eine GaAs-Verbindung umfasst oder aus einer GaAs-Verbindung besteht.

Ferner weist die III-V-Halbleiterdiode eine n⁻-Schicht mit einer Dotierstoffkonzentration von 10¹²-10¹⁶ cm⁻³ und einer Schichtdicke von 10-300 µm, sowie eine p⁺-Schicht mit einer Dotierstoffkonzentration von 5•10¹⁸ - 5•10²⁰ cm⁻³ und mit einer Schichtdicke größer 1 µm, wobei die n⁻-Schicht und die p⁺-Schicht eine GaAs-Verbindung umfassen oder aus einer GaAs-verbindung bestehen und das n⁺-Substrat und die n⁻-Schicht stoffschlüssig miteinander verbunden sind.

Zwischen n⁻-Schicht und der p⁺-Schicht ist eine n-dotierte Zwischenschicht mit einer Schichtdicke von 1 - 50 µm und einer Dotierstoffkonzentration von 10¹²-10¹⁷ cm⁻³ angeordnet, wobei die Zwischenschicht mit der n⁻-Schicht und mit der p⁺-Schicht stoffschlüssig verbunden ist.

Es versteht sich, dass die Zwischenschicht eine im Vergleich zu den stoffschlüssig verbundenen Schichten wenigstens eine unterschiedliche Dotierstoffkonzentration aufweist.

Ein Vorteil ist, dass sich mit den offenbarten III-V-Halbleiterdioden auf einfache Weise Sperrspannungen in einem Bereich von 200V - 3300 V mit kleineren Einschaltwiderständen und geringeren Kapazitäten pro Fläche als herkömmliche hochsperrende Dioden aus Si oder aus SiC herstellen lassen. Hierdurch sind Schaltfrequenzen von 30 kHz bis zu 0,5 GHz und Stromdichten von 0,5 A/mm² bis 5 A/mm² erreichbar.

Ein weiterer Vorteil ist, dass sich die III-V-Halbleiterdioden kostengünstiger als vergleichbare hochsperrende Dioden aus SiC herstellen lassen.

Insbesondere lassen sich die erfindungsgemäßen III-V-Halbleiterdioden als Freilaufdioden verwenden.

Es sei angemerkt, dass die erfindungsgemäßen III-V-Halbleiterdioden vorliegend kleine Einschaltwiderstände in einem Bereich zwischen 1 mOhm und 200 mOhm aufweisen. Die Kapazitäten pro Fläche liegen in einem Bereich zwischen 2 pF und 100 pF.

Ein anderer Vorteil der erfindungsgemäßen III-V-Halbleiterdiode ist eine hohe Temperaturfestigkeit von bis zu 300°C. Anders ausgedrückt lassen sich die III-V-Halbleiterdioden auch in heißen Umgebungen einsetzten.

In einer nicht erfindungsgemäßen Ausführungsform ist die Zwischenschicht p-dotiert ausgebildet und umfasst gemäß alternativer Weiterbildungen als Dotierstoffe Zink und / oder Silizium. Die Dotierstoffkonzentration der Zwischenschicht ist kleiner als die Dotierstoffkonzentration der p⁺-Schicht. Vorzugsweise ist die Dotierstoffkonzentration in einem Bereich zwischen einem Faktor 2 bis zu einem Faktor 100.000, d.h. fünf Größenordnungen kleiner.

Erfindugnsgemäß ist die Zwischenschicht n-dotiert ausgebildet und umfasst als Dotierstoff vorzugsweise Silizium. Die Dotierstoffkonzentration der Zwischenschicht ist kleiner als die Dotierstoffkonzentration des n⁺-Substrats. Vorzugsweise ist die Dotierstoffkonzentration bis zu einem Faktor 100 kleiner als in der n-Schicht.

In einer anderen Ausführungsform umfasst die p⁺-Schicht als Dotierstoff Zink. Die n⁻-Schicht und/oder das n⁺-Substrat umfassen als Dotierstoffe vorzugsweise Chrom und / oder Palladium.

In einer weiteren Ausführungsform ist ein stapelförmiger Schichtaufbau bestehend aus dem n⁺-Substrat, der n⁻-Schicht, der Zwischenschicht und der p⁺-Schicht monolithisch ausgebildet.

In einer weiteren Ausführungsform beträgt eine Gesamthöhe des stapelförmigen Schichtaufbaus bestehend aus dem n⁺-Substrat, der n⁻-Schicht, der Zwischenschicht und der p⁺-Schicht höchstens 150-500 µm.

Vorzugsweise ist eine Oberfläche des Schichtaufbaus viereckig, insbesondere rechteckig oder quadratisch und mit einer Kantenlänge in einem Bereich zwischen 1 mm und 20 mm ausgebildet. In einer Weiterbildung weisen die viereckigen Strukturen jeweils abgerundete Kanten und / oder Ecken auf, um Feldstärkespitzen insbesondere bei Spannungen oberhalb 500 V zu vermeiden.

In einer weiteren nicht erfindungsgemäßen Ausführungsform weist der stapelförmige Schichtaufbau bestehend aus dem p⁺-Substrat, der Zwischenschicht, der n⁻-Schicht und der n⁺- Schicht ein zwischen der n⁻-Schicht und der Zwischenschicht ausgebildeter Halbleiterbond auf. Es wird angemerkt, dass der Ausdruck Halbleiterbond synonym mit dem Ausdruck Waferbond verwendet wird. Der Schichtaufbau bestehend aus einem p⁺-Substrat und der Zwischenschicht und bildet einen ersten Teilstapel und der Schichtaufbau bestehend aus der n⁺-Schicht und einer n⁻-Schicht bildet einen zweiten Teilstapel. Der erste Teilstapel und der zweite Teilstapel sind jeweils monolithisch ausgebildet.

In einer nicht erfindungsgemäßen Weiterbildung wird der erste Teilstapel gebildet, in dem ausgehend von einem p⁺-Substrat mittels Epitaxie die Zwischenschicht hergestellt wird oder angeordnet ist. In einer nicht beanspruchten Ausführungsform weist die als p⁻-Schicht ausgebildete Zwischenschicht eine Dotierung kleiner als 10¹³ N/cm⁻³ oder eine Dotierung zwischen 10¹³ N/cm⁻³ und 10¹⁵ N/cm⁻³ auf. In einer Ausführungsform wird das p⁺-Substrat vor oder nach dem Bonden durch einen Schleifprozess auf eine Dicke zwischen 200 µm und 500 µm gedünnt.

In einer nicht erfindungsgemäßen Ausführungsform ist ein erster Teilstapel vorgesehen, in dem ausgehend von einem p⁺-Substrat mittels Epitaxie die Zwischenschicht angeordnet ist und des Weiteren ist ein zweiter Stapel vorgesehen, in dem ausgehend von einem n⁻-Substrat, das n⁻-Substrat mit dem zweiten Stapel durch einen Waferbondprozess verbunden ist.

In einer anderen nicht erfindungsgemäßen Ausführungsform wird der zweite Stapel gebildet, in dem ausgehend von einem n⁻-Substrat, das n⁻-Substrat mit dem zweiten Stapel durch einen Waferbondprozess verbunden wird oder ist. In einem weiteren Prozessschritt wird das n⁻-Substrat auf die gewünschte Dicke gedünnt. Vorzugsweise liegt die Dicke des n⁻-Substrats in einem Bereich zwischen 50 µm bis 250µm. Vorzugsweise liegt die Dotierung des n⁻-Substrats in einem Bereich zwischen 10¹³ N/cm⁻³ und 10¹⁵ N/cm⁻³. Ein Vorteil des Waferbonden ist es, dass sich dicke n⁻-Schichten ohne weiteres herstellen lassen. Ein langer Abscheideprozess bei der Epitaxie entfällt hierdurch. Auch lassen sich mittels des Bondens die Anzahl der Stapelfehler verringern.

In einer alternativen nicht erfindungsgemäßen Ausführungsform weist das n⁻-Substrat eine Dotierung größer als 10¹⁰ N/cm⁻³ und kleiner als 10¹³ N/cm⁻³ auf. In dem die Dotierung extrem gering ist, lässt sich das n⁻-Substrat auch als eine intrinsische Schicht auffassen.

In einer nicht erfindungsgemäßen Weiterbildung wird nach dem Dünnen des n⁻-Substrats mittels Epitaxie oder Hochdosisimplantation auf dem n⁻-Substrat die n⁺-Schicht in einem Bereich zwischen 10¹⁸ N/cm⁻³ und kleiner als 5×10¹⁹ N/cm⁻³ erzeugt. Das Dünnen des n⁻-Substrats erfolgt vorzugsweise mittels eines CMP Schrittes, d.h. mittels chemischen mechanischen Polierens.

In einer anderen nicht erfindungsgemäßen Weiterbildung wird auf der Vorderseite der Dioden-Struktur eine Hilfsschicht aufgetragen. Anschließend lässt die Rückseite der Dioden-Struktur dünnen und auf einem Träger ablegen. In einer anderen Weiterbildung wird anschließend die Vorderseite abgelöst.

In nicht erfindungsgemäßen Ausführungsform werden die Oberfläche des n⁺-Substrats und die Oberfläche des p⁺-Substrats metallisiert, um die Halbleiter-Diode elektrisch anzuschließen. Vorzugsweise wird die Kathode der Halbleiter-Diode nach der Metallisierung mit einer als Wärmesenke ausgebildeten Unterlage stoffschlüssig verbunden. Anders ausgedrückt, die Anode ist an der Oberfläche der Diode auf der p+-Schicht ausgebildet.

Untersuchungen für nicht erfindungsgemäßen Ausführungsformen haben gezeigt, dass sich mit bestimmten Kombinationen von einer p⁻- Zwischenschicht und n⁻-Schicht verschiedene Sperrspannungen erzielen lassen.

In einer ersten Variante umfasst die:
p⁻- Zwischenschicht eine Dicke zwischen 10 µm bis 25 µm und für die n⁻-Schicht eine Dicke zwischen 40 µm und 90 µm eine Sperrspannung von ca. 900 V ergibt.

In einer zweiten Variante umfasst die:
p⁻- Zwischenschicht eine Dicke zwischen 25 µm bis 25 µm und für die n⁻-Schicht eine Dicke zwischen 40 µm und 70 µm eine Sperrspannung von ca. 1200 V ergibt.

In einer dritten Variante umfasst die:
p⁻- Zwischenschicht eine Dicke zwischen 35 µm bis 50 µm und für die n⁻-Schicht eine Dicke zwischen 70µm und 150 µm und 70 µm eine Sperrspannung von ca. 1500 V ergibt.

Die Dioden in der ersten bis dritten Variante lassen sich hinsichtlich der Ausbildung der Raumladungszonen auch als Punsch- Dioden bezeichnen.

In einer vierten Variante umfasst die:
p⁻- Zwischenschicht eine Dicke zwischen 10 µm bis 25 µm und für die n⁻-Schicht eine Dicke zwischen 60 µm und 110 µm.

In einer fünften Variante umfasst die:
p⁻- Zwischenschicht eine Dicke zwischen 10 µm bis 25 µm und für die n⁻-Schicht eine Dicke zwischen 70 µm und 140.

In einer sechsten Variante umfasst die:
p⁻- Zwischenschicht eine Dicke zwischen 35 µm bis 50 µm und für die n⁻-Schicht eine Dicke zwischen 80µm und 200 µm.

Die Dioden in der vierten bis sechsten Variante lassen sich hinsichtlich der Ausbildung der Raumladungszonen auch als "non - reach - through" - Dioden bezeichnen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die:
- Figur 1: eine Ansicht auf eine erste III-V-Halbleiterdiode,
- Figur 2: eine Ansicht auf eine nicht erfindungsgemäße Ausführungsform einer Schichtenfolge
- Figur 3: eine Ansicht auf eine erfindungsgemäße Ausführungsform einer Schichtenfolge,
- Figur 4: eine Aufsicht auf die III-V-Halbleiterdiode aus Figur 1.

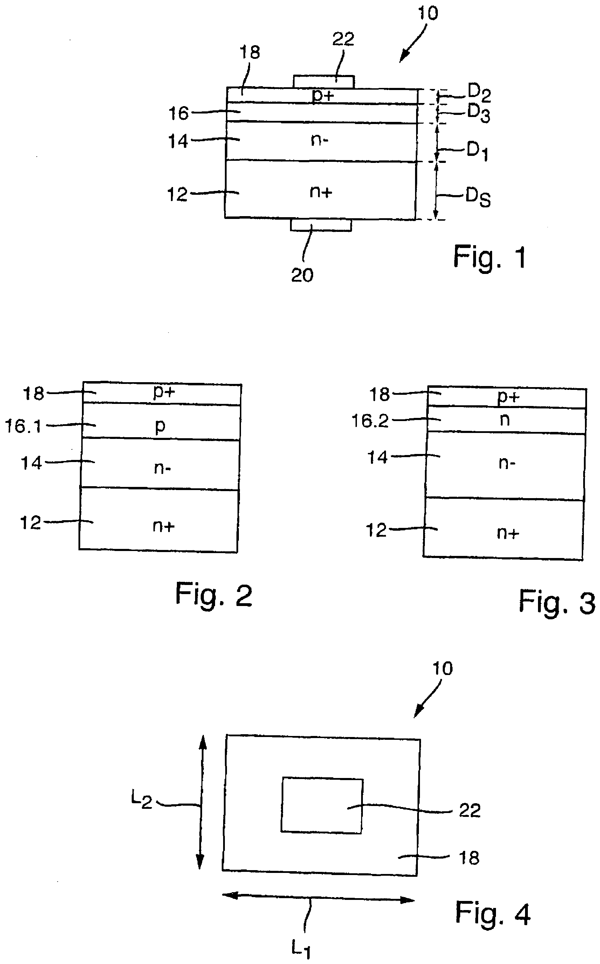

Die Abbildung der Figur 1 zeigt eine Ansicht einer stapelförmigen III-V-Halbleiterdiode 10, aufweisend ein n⁺-Substrat 12, eine mit dem Substrat 12 stoffschlüssig verbundene niedrig dotierte n⁻-Schicht 14, eine mit der n⁻-Schicht 14 stoffschlüssig verbundene Zwischenschicht 16, eine mit der Zwischenschicht 16 stoffschlüssig verbundene p⁺-Schicht 18 sowie einen ersten Kontakt 20 und einen zweiten Kontakt 22. Der erste Kontakt 20 ist stoffschlüssig mit einer Unterseite des n⁺-Substrats 12 verbunden, während der zweite Kontakt 22 stoffschlüssig mit einer Oberseite der p⁺-Schicht 18 verbunden ist.

Das n⁺-Substrat 12 ist stark n-dotiert und weist eine Dotierstoffkonzentration von 10¹⁹ cm⁻³. Eine Schichtdicke DS des Substrats 12 liegt zwischen 100 µm und 400 µm.

Die n⁻-Schicht 16 ist niedrig n-dotiert mit einer Dotierstoffkonzentration von 10¹²-10¹⁶ cm⁻³ und weist eine Schichtdicke D1 von 10-300 µm auf.

Die n-dotierte Zwischenschicht 14 weist eine Schichtdicke D3 von 1 - 50 µm und eine niedrige Dotierung mit einer Dotierstoffkonzentration von 10¹²-10¹⁷ cm⁻³ auf.

Die p⁺-Schicht 18 ist stark p-dotiert mit einer Dotierstoffkonzentration von 10¹⁹ cm⁻³ und einer Schichtdicke D2 größer 2 µm.

In den Abbildungen der Figuren 2 und 3 sind zwei alternative Ausführungsformen einer aus dem n⁺-Substrat 12, der n⁻-Schicht 14, der Zwischenschicht 16 und der p⁺-Schicht 18 bestehenden Schichtaufbaus 100 einer erfindungsgemäßen III-V-Halbleiterdiode dargestellt. Im Folgenden werden nur die Unterschiede zu der Abbildung der Figur 1 erläutert.

Der Schichtaufbau 100 kann gemäß einer nicht erfindungsgemäßen Ausführungsform eine niedrig p-dotierte Zwischenschicht 16.1 aufweisen, wie in Figur 2 dargestellt. Erfindungsgemäß weist die Schichtenfolge eine niedrig n-dotierte Zwischenschicht 16.2 auf, wie in Figur 3 dargestellt.

In der Abbildung der Figuren 4 ist eine Aufsicht auf die in Figur 1 gezeigte III-V-Halbleiterdiode dargestellt. Im Folgenden werden nur die Unterschiede zu der Abbildung der Figur 1 erläutert.

Der stapelförmige Schichtaufbau 100 der III-V-Halbleiterdiode 10 bestehend aus dem n⁺-Substrat 12, der n⁻-Schicht 14, der Zwischenschicht 16 und der p⁺-Schicht 18 weist einen rechteckigen Umfang und damit auch eine rechteckige Oberfläche mit den Kantenlängen L1 und L2 auf. Die auf der Oberfläche der Schichtenfolge 100 angeordnete Kontaktfläche 22 überdeckt nur einen Teil der Oberfläche.

Es versteht sich, dass in einer nicht dargestellten Ausführungsform weist der der Stapel auch viereckig Oberfläche auf. Insbesondere ist die Oberfläche quadratisch ausgeführt.

In einer anderen nicht dargestellten Ausführungsform sind bei den eckigen Ausführungen die Ecken verrundet, um Feldstärkespitzen bei hohen Spannungen zu vermeiden.

In einer anderen nicht dargestellten Ausführungsform ist die Oberfläche rund ausgeführt. Hierdurch werden Überhöhungen der Feldstärke besonders effektiv reduziert. Vorzugsweise ist die Oberfläche kreisförmig oder oval ausgeführt.

## Patentansprüche

1. Stapelförmige III-V-Halbleiterdiode (10) aufweisend
- ein n⁺-Substrat (12) mit einer Dotierstoffkonzentration von mindestens 10¹⁹cm⁻³ und einer Schichtdicke (DS) von 50-400 µm, wobei das n⁺-Substrat (12) eine GaAs-Verbindung umfasst oder aus einer GaAs Verbindung besteht,
- eine n⁻-Schicht (14) mit einer Dotierstoffkonzentration von 10¹²-10¹⁶ cm⁻³, einer Schichtdicke (D1) von 10-300 µm, wobei die n⁻-Schicht eine GaAs-Verbindung umfasst oder aus einer GaAs Verbindung besteht,
- eine p⁺-Schicht (18) mit einer Dotierstoffkonzentration von 5•10¹⁸-5•10²⁰cm⁻³, mit einer Schichtdicke (D2) größer 2 µm, wobei die p⁺-Schicht eine GaAs-Verbindung umfasst oder aus einer GaAs Verbindung besteht,
- wobei das n⁺-Substrat (12) und die n⁻-Schicht (14) stoffschlüssig miteinander verbunden sind, worin zwischen der n⁻-Schicht (14) und der p⁺-Schicht (18) eine dotierte Zwischenschicht (16) mit einer Schichtdicke (D3) von 1-50 µm und einer Dotierstoffkonzentration von 10¹²-10¹⁷ cm⁻³ angeordnet ist,
wobei die Zwischenschicht (16) mit der n⁻-Schicht (14) und mit der p⁺-Schicht (18) stoffschlüssig verbunden ist, und
die Zwischenschicht (16) n-dotiert ausgebildet ist, und
die Zwischenschicht eine im Vergleich zu den stoffschlüssig verbundenen Schichten unterschiedliche Dotierstoffkonzentration aufweist.

2. III-V-Halbleiterdiode (10) nach Anspruch 1, **dadurch gekennzeichnet, dass** die Zwischenschicht (16) Silizium und / oder Zinn als Dotierstoff umfasst.

3. III-V-Halbleiterdiode (10) nach Anspruch 1 oder Anspruch 2, **dadurch gekennzeichnet, dass** die Dotierstoffkonzentration der Zwischenschicht (16) um bis zu einem Faktor 100 kleiner als die Dotierstoffkonzentration des n⁻-Schicht (14) ist.

4. III-V-Halbleiterdiode (10) nach einem der Ansprüche 1 bis 3, **dadurch gekennzeichnet, dass** die p⁺-Schicht (18) Zink als Dotierstoff umfasst.

5. III-V-Halbleiterdiode (10) nach einem der Ansprüche 1 bis 4, **dadurch gekennzeichnet, dass** die n⁻-Schicht (14) Silizium und/oder Chrom und/oder Palladium und/oder Zinn als Dotierstoff und/oder das n⁺-Substrat (12) Chrom und/oder Palladium und/oder Zinn als Dotierstoff umfassen.

6. III-V-Halbleiterdiode (10) nach einem der Ansprüche 1 bis 5, **dadurch gekennzeichnet, dass** ein stapelförmiger Schichtaufbau (100) bestehend aus dem n⁺-Substrat (12), der n⁻-Schicht (14), der Zwischenschicht (16) und der p⁺-Schicht (18) monolithisch ausgebildet ist.

7. III-V-Halbleiterdiode (10) nach einem der Ansprüche 1 bis 6, **dadurch gekennzeichnet, dass** eine Gesamthöhe eines stapelförmigen Schichtaufbaus (100) bestehend aus dem n⁺-Substrat (12), der n⁻-Schicht (14), der Zwischenschicht (16) und der p⁺-Schicht (18) höchstens 150-500 µm beträgt.

8. III-V- Halbleiterdiode nach einem der Ansprüche 1 bis 7, **dadurch gekennzeichnet, dass** der stapelförmige Schichtaufbau (100) bestehend aus dem n⁺-Substrat (12), der n⁻-Schicht (14), der Zwischenschicht (16) und der p⁺-Schicht (18)eine rechteckige oder quadratische Oberfläche mit Kantenlängen (L1, L2) zwischen 1 mm und 10 mm aufweist.

9. III-V- Halbleiterdiode nach einem der Ansprüche 1 bis 7, **dadurch gekennzeichnet, dass** der stapelförmige Schichtaufbau (100) bestehend aus dem n⁺-Substrat (12), der n⁻-Schicht (14), der Zwischenschicht (16) und der p⁺-Schicht (18) eine runde, vorzugsweise ovale oder kreisförmige Oberfläche aufweist.

## Claims

1. Stack-shaped lll-V semiconductor diode (10) comprising
- an n⁺ substrate (12) with a doping substance concentration of at least 10¹⁹cm⁻³ and a layer thickness (DS) of 50 - 400 µm, wherein the n⁺ substrate (12) comprises a GaAs compound or consists of a GaAs compound,
- an n⁻ layer (14) with a doping substance concentration of 10¹² - 10¹⁶ cm⁻³ and a layer thickness (D1) of 100 - 300 µm, wherein the n⁻ layer comprises a GaAs compound or consists of a GaAs compound,
- a p⁺ layer (18) with a doping substance concentration of 5 • 10¹⁸ - 5 • 10²⁰ cm⁻³, with a layer thickness (D2) greater than 2 µm, wherein the p⁺ layer comprises a GaAs compound or consists of a GaAs compound,
- wherein the n⁺ substrate (12) and the n⁻ layer (14) are connected with one another by material couple,
wherein a doped intermediate layer (16) with a layer thickness (D3) of 1 - 50 µm and doping substance concentration of 10¹² - 10¹⁷ cm⁻³ is arranged between the n⁻ layer (14) and the p⁺ layer (18),
wherein the intermediate layer (16) is connected with the n⁻ layer (14) and with the p⁺ layer (18) by material couple,
the intermediate layer (16) is n-doped and
the intermediate layer has a different doping substance concentration by comparison with the layers connected by material couple.

2. III-V semiconductor diode (10) according to claim 1, **characterised in that** the intermediate layer (16) comprises silicon and/or tin as doping substance.

3. III-V semiconductor diode (10) according to claim 1 or claim 2, **characterised in that** the doping substance concentration of the intermediate layer (16) is smaller than the doping substance concentration of the n⁻ layer (14) by up to factor 100.

4. III-V semiconductor diode (10) according to any one of claims 1 to 3, **characterised in that** the p⁺ layer (18) comprises zinc as doping substance.

5. III-V semiconductor diode (10) according to any one of claims 1 to 4, **characterised in that** the n⁻ layer (14) comprises silicon and/or chromium and/or palladium and/or tin as doping substance and/or the n⁺ substrate (12) comprises chromium and/or palladium and/or tin as doping substance.

6. lll-V semiconductor diode (10) according to any one of claims 1 to 5, **characterised in that** a stack-shaped layer construction (100) consisting of the n⁺ substrate (12), the n⁻ layer (14), the intermediate layer (16) and the p⁺ layer (18) is of monolithic construction.

7. III-V semiconductor diode (10) according to any one of claims 1 to 6, **characterised in that** an overall height of a stack-shaped layer construction (100) consisting of the n⁺ substrate (12), the n⁻ layer (14), the intermediate layer (16) and the p⁺ layer (18) is at most 150 - 500 µm.

8. III-V semiconductor diode (10) according to any one of claims 1 to 7, **characterised in that** the stack-shaped layer construction (100) consisting of the n⁺ substrate (12), the n⁻ layer (14), the intermediate layer (16) and the p⁺ layer (18) has a rectangular or square surface with edge lengths (L1, L2) between 1 mm and 10 mm.

9. III-V semiconductor diode (10) according to any one of claims 1 to 7, **characterised in that** the stack-shaped layer construction (100) consisting of the n⁺ substrate (12), the n⁻ layer (14), the intermediate layer (16) and the p⁺ layer (18) has a round, preferably oval or circular, surface.

## Revendications

1. Diode semi-conductrice III-V à empilement (10), présentant :
un substrat n⁺ (12) qui présente une concentration de dopant d'au moins 10¹⁹cm⁻³ et une épaisseur de couche (DS) comprise entre 50 µm et 400 µm, dans laquelle le substrat n⁺ (12) comprend un composé GaAs ou se compose d'un composé GaAs,
une couche n⁻ (14) qui présente une concentration de dopant comprise entre 10¹²cm⁻³ et 10¹⁶cm⁻³ et une épaisseur de couche (D1) comprise entre 10 µm et 300 µm, dans laquelle la couche n⁻ comprend un composé GaAs ou se compose d'un composé GaAs,
une couche p⁺ (18) qui présente une concentration de dopant comprise entre 5.10¹⁸cm⁻³ et 5.10²⁰cm⁻³ et une épaisseur de couche (D2) supérieure à 2 µm, dans laquelle la couche p⁺ comprend un composé GaAs ou se compose d'un composé GaAs,
dans laquelle le substrat n⁺ (12) et la couche n⁻ (14) sont matériellement assemblés l'un à l'autre,
dans laquelle une couche intermédiaire dopée (16) qui présente une épaisseur de couche (D3) comprise entre 1 µm et 50 µm et une concentration de dopant comprise entre 10¹²cm⁻³ et 10¹⁷cm⁻³ est disposée entre la couche n⁻ (14) et la couche p⁺ (18),
dans laquelle la couche intermédiaire (16) est matériellement assemblée à la couche n⁻ (14) et à la couche p⁺ (18), et
dans laquelle:
la couche intermédiaire (16) est dopée n, et
la couche intermédiaire présente une concentration en dopant différente par rapport aux couches matériellement assemblées l'une à l'autre.

2. Diode semi-conductrice III-V (10) selon la revendication 1, **caractérisée en ce que** la couche intermédiaire (16) comprend du silicium et/ou de l'étain comme dopant.

3. Diode semi-conductrice III-V (10) selon la revendication 1 ou la revendication 2, **caractérisée en ce que** la concentration de dopant de la couche intermédiaire (16) est inférieure jusqu'à un facteur 100 à la concentration de dopant de la couche n⁻ (14).

4. Diode-semi-conductrice III-V (10) selon l'une quelconque des revendications 1 à 3, **caractérisée en ce que** la couche p⁺ (18) comprend du zinc comme dopant.

5. Diode semi-conductrice III-V (10) selon l'une quelconque des revendications 1 à 4, **caractérisée en ce que** la couche n⁻ (14) comprend du silicium et/ou du chrome et/ou du palladium et/ou de l'étain comme dopant et/ou le substrat n⁺ (12) comprend du chrome et/ou du palladium et/ou de l'étain comme dopant.

6. Diode semi-conductrice III-V (10) selon l'une quelconque des revendications 1 à 5, **caractérisée en ce qu'**une structure de couches empilées (100), composée du substrat n⁺ (12), de la couche n⁻ (14), de la couche intermédiaire (16) et de la couche p⁺ (18), est monolithique.

7. Diode semi-conductrice III-V (10) selon l'une quelconque des revendications 1 à 6, **caractérisée en ce qu'**une hauteur totale d'une structure de couches empilées (100), composée du substrat n⁺ (12), de la couche n⁻ (14), de la couche intermédiaire (16) et de la couche p⁺ (18) vaut au plus de 150 µm à 500 µm.

8. Diode semi-conductrice III-V (10) selon l'une quelconque des revendications 1 à 7, **caractérisée en ce que** la structure de couches empilées (100), composée du substrat n⁺ (12), de la couche n⁻ (14), de la couche intermédiaire (16) et de la couche p⁺ (18), présente une surface rectangulaire ou carrée, avec des longueurs de côté (L1, L2) comprises entre 1 mm et 10 mm.

9. Diode semi-conductrice III-V (10) selon l'une quelconque des revendications 1 à 7, **caractérisée en ce que** la structure de couches empilées (100), composée du substrat n⁺ (12), de la couche n⁻ (14), de la couche intermédiaire (16) et de la couche p⁺ (18), présente une surface ronde, de préférence ovale ou circulaire.
